# EUROPEAN PATENT SPECIFICATION

(11) **EP 0 899 878 B1**
(45) Date of publication and mention of the grant of the patent: **05.11.2003**
(21) Application number: 97830432.7
(22) Date of filing: 29.08.1997
(51) Int. Cl.: H03K 3/00, H03K 3/356, H03K 3/037

(54) **A toggle flip-flop with a reduced integration area**
Kippschaltung mit reduzierter Integrationsfläche
Bascube bistable à surface d'intégration réduite

(43) Date of publication of application: 03.03.1999
(73) Proprietor: STMicroelectronics S.r.l., 20041 Agrate Brianza (Milano) (IT)
(72) Inventor: Rossi, Annamaria, 20017 Rho (Milano) (IT); Fucili, Giona, 20129 Milano (IT); Cane, Marcello, 20017 Rho (Milano) (IT); Nessi, Maurizio, 22100 Como (IT)
(74) Representative: Botti, Mario

(56) References cited:
- EP-A- 0 249 119
- EP-A- 0 541 840
- US-A- 4 233 524
- US-A- 5 306 970

## Description

This invention as it is defined in the appended claims relates to logic networks of the sequential type, and in particular to bistable circuits of the T type, also referred to in the literature as toggle flip-flops (FFTs).

Exemplary applications thereof include binary counters and synchronous frequency dividers.

Considering binary counters, a one-bit counter has an input and n outputs which are the encoded form of the number of pulses that have been applied to the input from the initial time when the counter is reset.

Therefore, the output states are 0,1,2,...,m, 0,1,2,...,m. The n outputs allow 2ⁿ different numbers to be encoded, i.e. m<2ⁿ-1.

For a sinchronous binary counter, the outputs are the numbers 0,1,...,2ⁿ-1 expressed in the binary system. The transfer function is [C]=[C]+1 (mod 2ⁿ).

This function has the following equations:${\text{y}}_{\text{0}} {\text{= y}}_{\text{0}} \text{XOR 1}$ yᵢ=yᵢ XOR yᵢ₋₁ XOR yᵢ₋₂...XOR with y₀ i=1,2,...,n-1, and where XOR is the Exclusive OR logic operation.

These equations do point to using the toggle flip-flop cell.

The toggle flip-flop changes over when T=1, otherwise the FFT cell would store the previous output value.

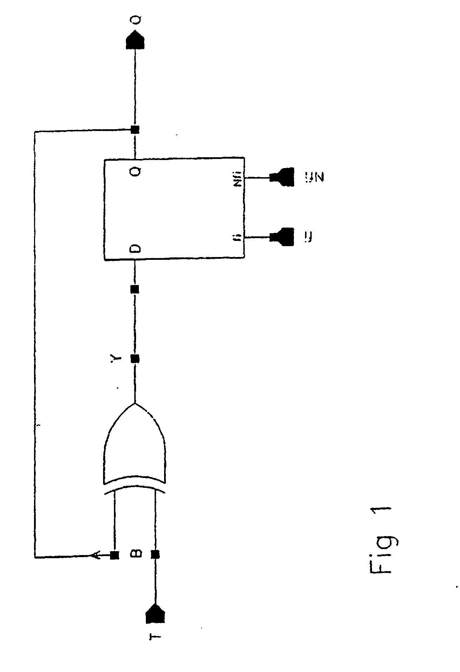

As shown in Figure 1 of the drawings, and as well known to the skilled persons in the art, a toggle flip-flop for use in monolithically integrated circuit devices generally comprises a flip-flop of the D type, FFD, and a XOR logic gate circuit. The document EP-A-0 541 840 also discloses such a toggle flip-flop.

The XOR circuit has its output terminal connected to the input terminal of FFO and an input terminal connected to the output terminal of the flip-flop.

The other input terminal is the T input of the resultant flip-flop of the T type.

Let D be the input data of FFD and Q the output data, the equation at the input becomes:$\text{D = (T) XOR(Q),}$ i.e. the same type as the equations for the binary counter.

The most commonly adopted constructions for a flip-flop of the T type are as detailed herein below.

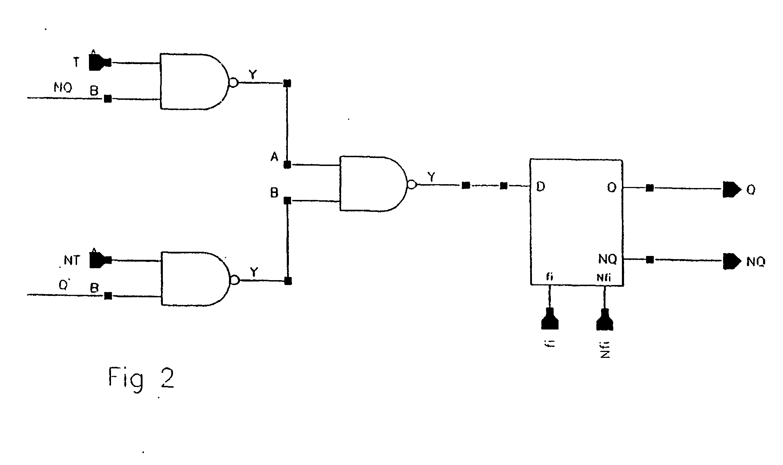

One construction provides standard logic gates for the XOR input gate, and a cascade-connected flip-flop of the D type. This solution has an advantage in that it has good driving capability. But where NAND gates are used, for example, a large number of transistors (16=3 NANDs+2NOTs) and complementary input signals (T, NT, Q, NQ) become a necessty, as shown in Figure 2 of the drawings.

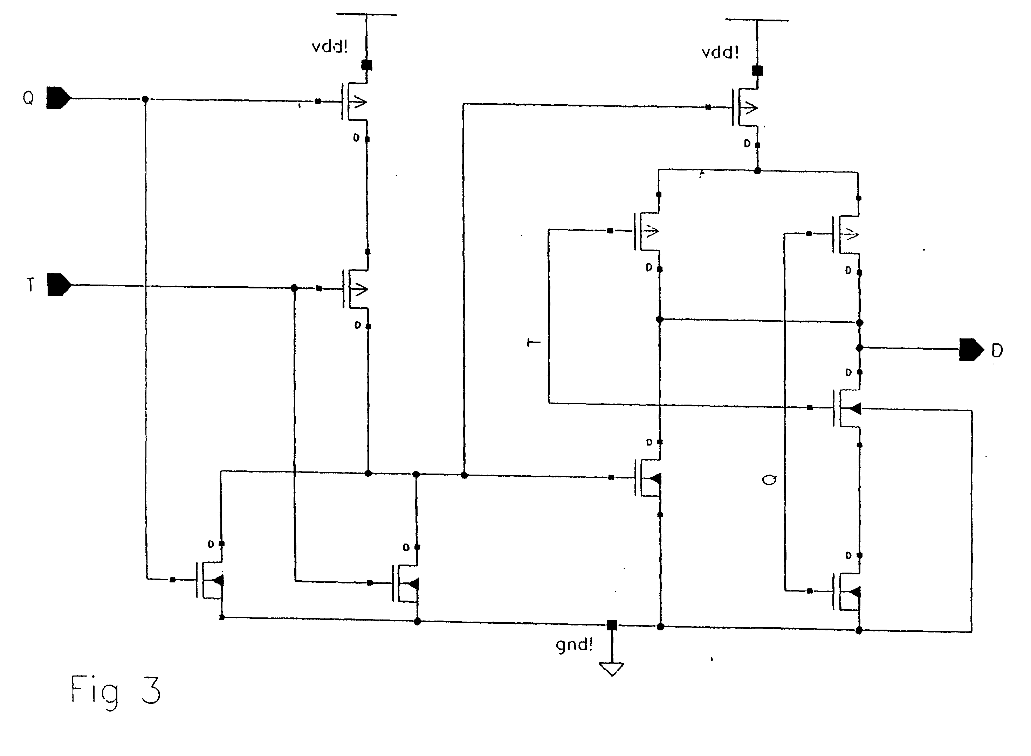

A similar construction, retaining the valuable driving features of the former, can be implemented -- so long as a complex gate of the type shown in Figure 3 is used for the XOR gate -- to use a smaller number of transistors (10=complex gate) and require no complementary signals.

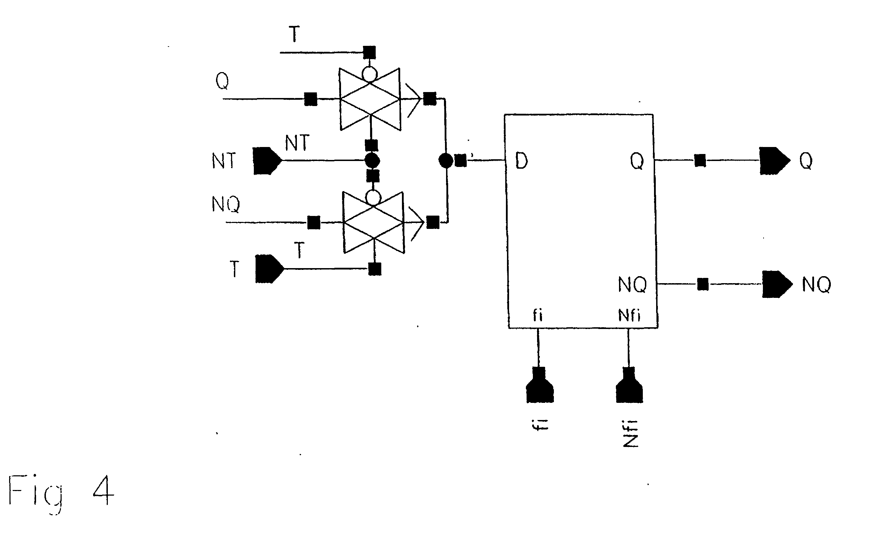

However, by using the transfer gates shown in Figure 4 of the drawings, the number of transistors could be further reduced (8=2 transfer gates+NOTs), at the cost of a lower driving capability than that of the previous solutions and of providing complementary input signals.

The last-mentioned construction can be preferred where savings in integration area are a condition.

The underlying technical problem of this invention is to provide a toggle flip-flop which requires no complementary input signals and has good driving capability, while requiring a significantly smaller number of transistors for implemennting the XOR input gate.

This technical problem is solved by a flip-flop as previously indicated and defined in the characterizing part of the appended claims to this specification.

The features and advantages of a flip-flop of the T type according to the invention can be appreciated from the following description of an embodiment thereof, given by way of non-limitative example in relation to the accompanying drawings.

In the drawings:
Figure 1 is a schematic diagram of a flip-flop of the T type as implemented by a flip-flop of the D type and a XOR logic gate;
Figures 2, 3 and 4 show prior art embodiments of the XOR logic gate employed for a flip-flop of the T type;
Figure 5 shows a prior art embodiment of a flip-flop of the D type having an inverting input stage; and
Figure 6 shows the modified input stage that characterizes a flip-flop of the T type according to the invention.

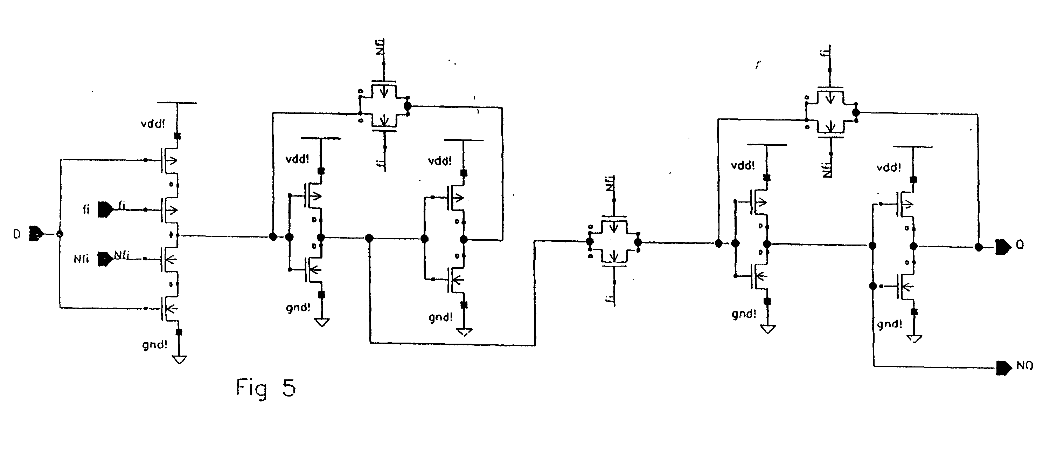

Shown in Figure 5 is a flip-flop of the D type, having a master-slave configuration and an input stage of the inverting type to regenerate the signal applied to the input terminal D, as generally implemented in the state of the art by transistors of the complementary type.

The master-slave configuration can be implemented in different circuit forms, but a buffer tristate with a high-impedance isolating and decoupling function is generally employed for the input stage.

According to the invention, a single input stage is produced for the D-type flip-flop, thereby to provide a novel FFT structure having the aforementioned features.

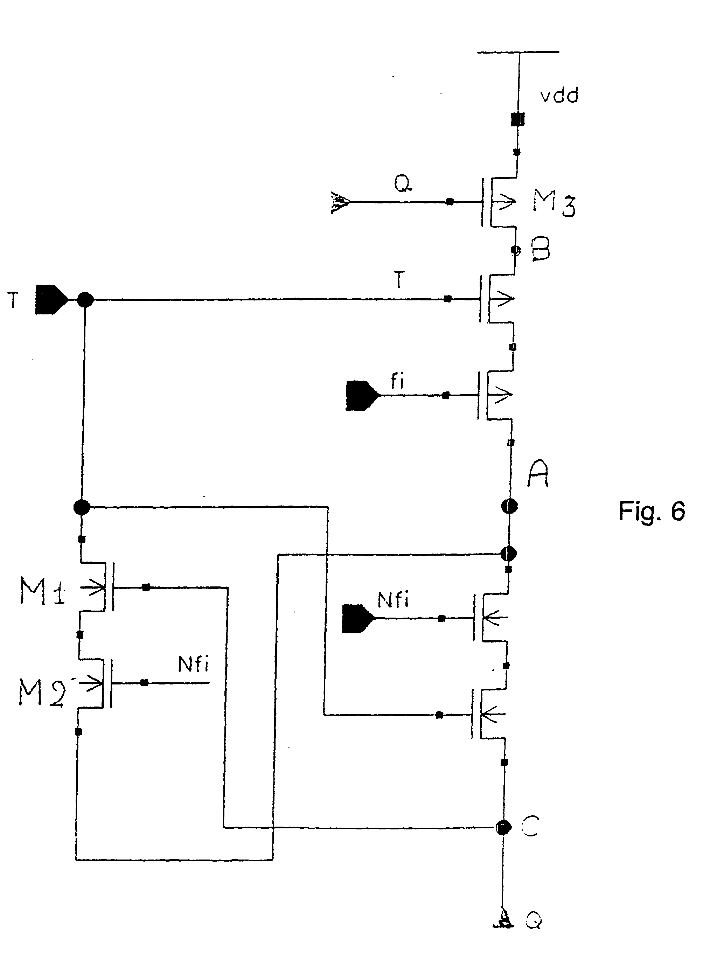

Assume a static master-slave FFD of the type shown in Figure 5, having an inverting input stage. The novel input stage to the flip-flop in Figure 6 performs the XNOR function (equivalent to the XOR gate plus the inverting input stage of the flip-flop). This novel stage has, compared to the previous ones, a smaller number of transistors, requires no complementary signals, and has good driving capability.

As shown in Figure 6, only 3 transistors are used additionally to those comprising the standard inverting input stage, which stage is driven by standard timing signals fi and Nfi (with non-overlapping phases).

Unchanged is the portion, corresponding to the original input stage of the D-type flip-flop, which is included between the input terminal T, the output circuit node A and the connection circuit nodes B and C.

According to the invention, the novel XNOR input stage comprises first and second transistors, M₁ and M₂, which are connected in series with each other, through respective source and drain terminals, between the input terminal T and the output circuit node A.

The gate terminal of M₁ is connected to the node C, while the gate terminal of M₂ is applied the timing signal Nfi.

According to the invention, a third transistor M₃ is connected between the circuit power supply line, Vdd, and the circuit node B.

Also in accordance with the invention, the output terminal of the flip-flop, corresponding to the output terminal Q of the D-type flip-flop, is feedback connected to the gate terminal of the transistor M₃ and the circuit node C.

In Figure 6, the feedback connections are only symbolically depicted for simplicity.

Taking the input stage alone, the truth table that ties together the three inputs (Q, T, fi) and the output node A, is the following:

**TABLE**

| T | Q | fi | A |
|---|---|---|---|
| 0 | 0 | 0 | 1 |
| 0 | 0 | 1 | X |
| 0 | 1 | 0 | 0 |
| 0 | 1 | 1 | X |
| 1 | 0 | 0 | 0 |
| 1 | 0 | 1 | X |
| 1 | 1 | 0 | 1 |
| 1 | 1 | 1 | X |

The Table reads as follows:
0 = ground potential, GND;
1 = vdd;
X = tristate condition;
fi = clock signal, Nfi being equivalent to negated fi.

In conclusion, the performance of this flip-flop of the T type is comparable to that of the previous ones, but is obtained with minimum area.

Where a BCD or mixed technology is used, area optimization is a condition.

The above advantages are specially useful with counter implementations where n is large, the saving in area as n is increased being self-evident.

Modifications or substitutions may be made unto the embodiment described hereinabove, in manners known to the skilled ones.

In fact, the invention applicability need not be limited to an inverting input buffer, or to one of the tristate type.

## Claims

1. A logic network of the sequential type including a flip-flop of the D type, having an input gate for transmitting signals to a bistable output circuit, said input gate having first (B) and second (C) terminals, a signal input terminal which forms an input terminal of the network (T), and a signal output circuit node (A) for connection to the bistable input circuit, and being controlled jointly with the bistable circuits of the flip-flop by timing signals which are synchronized in a predetermined manner and applied to control terminals (fi,Nfi) of the flip-flop, **characterized in that** it comprises first (M₁), second (M₂) and third (M₃) electronic switches, each having first, second and control terminals, the first and second switches being connected, in series with each other through their respective first and second terminals, between the input terminal (T) of the input gate and the output node thereof (A), the third switch being connected, with its first and second terminals between the first terminal of the input gate (T) and a network power supply line (Vdd), and that the control terminals of the first and third switches and the second terminal of the input gate are connected to an output terminal of the flip-flop (Q) forming an output terminal of the network, timing signals (Nfi) synchronized in a predetermined manner being applied to the control terminal of the second switch (M₁).

2. A logic network according to Claim 1, **characterized in that** the input gate for transmitting signals is an interface circuit of the tristate type and the electronic switches are transistors of the MOS type.

3. A logic network according to Claim 2, **characterized in that** the third electronic switch (M₃) is a transistor which is complementary to the transistors of the first (M₁) and second (M₂) electronic switches.

4. A logic network according to Claim 3, **characterized in that** the timing signal synchronization is predetermined such that the network operates in the toggle flip-flop (FFT) mode.

5. A binary device, **characterized in that** it comprises at least one logic network according to any one of Claims 1, 2, 3 and 4.

6. A synchronous frequency divider device, **characterized in that** it comprises at least one logic network according to any one of Claims 1, 2, 3 and 4.

## Patentansprüche

1. Logiknetzwerk der sequentiellen Bauart mit einer Kippschaltung der D-Bauart, das ein Eingangsgatter zum Übertragen von Signalen an eine bistabile Ausgangsschaltung, wobei das Eingangsgatter einen ersten (B) und zweiten (C) Anschluss aufweist, einen Signaleingangsanschluss, der einen Eingangsanschluss des Netzwerks (T) bildet, und einen Signalausgangsschaltungsknoten (A) zum Verbinden mit der bistabilien Eingangsschaltung hat und gemeinsam mit den bistabilien Schaltungen der Kippschaltung durch Taktsignale gesteuert wird, die auf vorbestimmte Weise synchronisiert und an die Steueranschlüsse (fi,Nfi) der Kippschaltung angelegt sind, **dadurch gekennzeichnet, dass** es einen ersten (M₁), zweiten (M₂) und dritten (M₃) elektronischen Schalter umfasst, die jeweils einen ersten, einen zweiten und einen Steueranschluss aufweisen, wobei der erste und zweite Schalter über ihren jeweiligen ersten und zweiten Anschluss zwischen dem Eingangsanschluss (T) des Eingangsgatters und dessen Ausgangsknoten (A) in Reihe miteinander geschaltet sind und der dritte Schalter mit dem ersten und zweiten Anschluss zwischen den ersten Anschluss des Eingangsgatters (T) und einer Netzwerkenergieversorgungsleitung (Vdd) angeschlossen ist, und dass die Steueranschlüsse des ersten und dritten Schalters und der zweite Anschluss des Eingangsgatters mit einem Ausgangsanschluss der Kippschaltung (Q) verbunden sind, der einen Ausgangsanschluss des Netzwerks bildet, wobei auf vorbestimmte Weise synchronisierte Taktsignale (Nfi) an den Steueranschluss des zweiten Schalters (M₁) angelegt sind.

2. Logiknetzwerk nach Anspruch 1, **dadurch gekennzeichnet, dass** das Eingangsgatter zum Übertragen von Signalen eine Interface-Schaltung der Dreizustandsbauart ist und die elektronischen Schalter Transistoren der MOS-Bauart sind.

3. Logiknetzwerk nach Anspruch 2, **dadurch gekennzeichnet, dass** der dritte elektronische Schalter (M₃) ein Transistor ist, der komplementär zu den Transistoren des ersten (M₁) und zweiten (M₂) elektronischen Schalters ist.

4. Logiknetzwerk nach Anspruch 3, **dadurch gekennzeichnet, dass** die Taktsignalsynchronisierung so vorherbestimmt ist, dass das Netzwerk im bistabilen Kippschaltungs(FET)-Modus arbeitet.

5. Binäres Bauelement, **dadurch gekennzeichnet, dass** es mindestens ein Logiknetzwerk nach einem der Ansprüche 1, 2, 3 und 4 umfasst.

6. Synchrone Frequenzteilervorrichtung, **dadurch gekennzeichnet, dass** sie mindestens ein Logiknetzwerk nach einem der Ansprüche 1, 2, 3 und 4 umfasst.

## Revendications

1. Réseau logique de type séquentiel incluant une bascule de type D, ayant une grille d'entrée qui transmet des signaux vers un circuit bistable de sortie, ladite grille d'entrée ayant une première borne (B) et une deuxième borne (C), une borne d'entrée du signal formant la borne d'entrée (T) du réseau, et un noeud de circuit de sortie de signal (A) permettant la connexion au circuit bistable d'entrée et étant commandé, conjointement aux circuits bistables de la bascule, par des impulsions de commande synchronisées de manière prédéterminée et appliquées aux bornes de commande (fi, Nfi) de la bascule, **caractérisée en ce qu'**il comprend un premier (M1), un deuxième (M2) et un troisième (M3) interrupteurs électroniques, chacun étant équipé d'une première et d'une deuxième bornes ainsi que d'une borne de commande, les premier et deuxième interrupteurs étant connectés en série l'un à l'autre par leurs première et deuxième bornes respectives, entre la borne d'entrée (T) de la grille d'entrée et le noeud de sortie (A), le troisième interrupteur étant connecté avec ses première et deuxième bornes entre la première borne de la grille d'entrée (T) et une ligne d'alimentation (Vdd) du réseau, et **en ce que** les bornes de commande des premier et troisième interrupteurs et la deuxième borne de la grille d'entrée sont connectées à une borne de sortie de la bascule (Q) formant une borne de sortie du réseau, les impulsions de commande (Nfi) synchronisées de manière prédéterminée étant appliquées à la borne de commande du deuxième interrupteur (M2).

2. Réseau logique selon la revendication 1, **caractérisé en ce que** la grille d'entrée qui transmet des signaux est un circuit d'interface de type trois états, et **en ce que** les interrupteurs électroniques sont des transistors du type MOS.

3. Réseau logique selon la revendication 2, **caractérisé en ce que** le troisième interrupteur électronique (M3) est un transistor complémentaire aux transistors des premier (M1) et deuxième (M2) interrupteurs électroniques.

4. Réseau logique selon la revendication 3, **caractérisé en ce que** la synchronisation des impulsions de commande est prédéterminée de sorte que le réseau fonctionne en mode interrupteur à bascule (FFT).

5. Dispositif binaire, **caractérisé en ce qu'**il contient au moins un réseau logique selon l'une des revendications 1, 2, 3 ou 4.

6. Dispositif diviseur de fréquence synchrone, **caractérisé en ce qu'**il contient au moins un réseau logique selon l'une des revendications 1, 2, 3 ou 4.
